# EUROPÄISCHE PATENTSCHRIFT

(11) **EP 2 543 083 B1**
(45) Veröffentlichungstag und Bekanntmachung des Hinweises auf die Patenterteilung: **11.10.2017**
(21) Anmeldenummer: 11703686.3
(22) Anmeldetag: 15.02.2011
(51) Int. Cl.: H01L 33/40, H01L 33/46, H01L 33/54, H01L 33/60, H01L 33/38

(54) **LEUCHTDIODENCHIP**
LIGHT EMITTING DIODE CHIP
PUCE DE DIODE ÉLECTROLUMINESCENTE

(30) Priorität: 01.03.2010 DE 102010009717
(43) Veröffentlichungstag der Anmeldung: 09.01.2013
(73) Patentinhaber: OSRAM Opto Semiconductors GmbH, 93055 Regensburg (DE)
(72) Erfinder: MAUTE, Markus, 93087 Alteglofsheim (DE); ENGL, Karl, 93080 Pentling (DE); RAMMELSBERGER, Stefanie, 93197 Zeitlarn (DE); GMEINWIESER, Nikolaus, 93083 Obertraubling (DE); EIBL, Johann, 93192 Wald (DE)
(74) Vertreter: Epping - Hermann - Fischer
(86) Internationale Anmeldenummer: PCT/EP2011/052233
(87) Internationale Veröffentlichungsnummer: WO 2011/107344

(56) Entgegenhaltungen:
- WO-A1-2005/069389
- DE-A1-102007 022 947
- JP-A- 2005 209 734
- JP-A- 2006 024 750
- US-A1- 2003 015 721
- US-A1- 2008 185 609
- US-A1- 2009 250 713

## Beschreibung

Die Erfindung betrifft einen Leuchtdiodenchip.

Diese Patentanmeldung beansprucht die Priorität der deutschen Patentanmeldung 10 2010 009 717.9. Aus der Druckschrift WO 2008/131735 A1 ist ein Leuchtdiodenchip bekannt, bei dem eine erste und zweite elektrische Anschlussschicht an einer der Strahlungsaustrittsfläche gegenüberliegenden Rückseite des Leuchtdiodenchips angeordnet und mittels einer Trennschicht elektrisch voneinander isoliert sind, wobei sich ein Teilbereich der zweiten elektrischen Anschlussschicht von der Rückseite durch einen Durchbruch der aktiven Schicht hindurch in Richtung zu der Vorderseite des Leuchtdiodenchips hin erstreckt. Eine derartige Kontaktierung eines Halbleiterchips hat den Vorteil, dass die Strahlungsaustrittsfläche frei von Kontaktflächen sein kann und somit die emittierte Strahlung nicht abgeschattet wird.

Bei dem Leuchtdiodenchip handelt es sich um einen so genannten Dünnfilm-Leuchtdiodenchip, bei dem das ursprüngliche Aufwachssubstrat der Halbleiterschichtenfolge abgelöst ist und stattdessen die Halbleiterschichtenfolge an einer dem ursprünglichen Aufwachssubstrat gegenüberliegenden Seite mittels einer Lotschicht mit einem Träger verbunden ist. Bei einem derartigen Dünnfilm-Leuchtdiodenchip ist es vorteilhaft, wenn die dem Träger zugewandte Seite der Halbleiterschichtenfolge mit einer Spiegelschicht versehen ist, um in die Richtung des Trägers emittierte Strahlung in die Richtung der Strahlungsaustrittsfläche umzulenken und dadurch die Strahlungsausbeute zu erhöhen.

Für den sichtbaren Spektralbereich ist insbesondere Silber als Material für die Spiegelschicht geeignet. Allerdings ist es bei einer Spiegelschicht aus Silber schwierig, sowohl eine gute Haftung auf dem Halbleitermaterial, einen guten elektrischen Anschluss an das Halbleitermaterial, eine hohe Reflexion als auch einen zuverlässigen Schutz vor Korrosion oder Migration des Silbers in benachbarte Schichten zu erzielen.

Um die Haftung einer Spiegelschicht aus Silber auf einem Halbleitermaterial zu verbessern, kann eine Haftvermittlerschicht zwischen der Halbleiteroberfläche und der Spiegelschicht eingefügt werden. Allerdings wird durch eine derartige Haftvermittlerschicht zwischen dem Halbleitermaterial und der Spiegelschicht in der Regel die Reflektivität reduziert. Eine solche Haftvermittlerschicht ist daher in der Regel sehr dünn aufzubringen, wodurch die Prozesskontrolle erschwert wird.

In der Druckschrift US 2009/0250713 A1 wird ein reflektierender Kontakt für ein lichtemittierendes Halbleiterbauelement beschrieben, der zwei Spiegelschichten und eine dazwischen angeordnete dünne Schicht mit hoher Elektronegativität aufweist.

Die Druckschrift WO 2005/069389 A1 beschreibt ein Nitridverbindungshalbleiterbauelement mit einer ohmschen Elektrodenschicht, die eine an das Halbleitermaterial angrenzende Kontaktmetallschicht, eine Spiegelschicht und eine auf der Spiegelschicht angeordnete Diffusionsbarriereschicht aufweist.

Der Erfindung liegt die Aufgabe zugrunde, einen Leuchtdiodenchip mit einer rückseitigen Spiegelschicht anzugeben, bei dem sich die Spiegelschicht insbesondere durch eine gute Haftung auf dem Halbleitermaterial, einen guten elektrischen Anschluss an das Halbleitermaterial, eine hohe Reflexion und einen Schutz vor Korrosion, Degradation oder Migration des Silbers in benachbarte Schichten auszeichnet.

Diese Aufgabe wird durch einen Leuchtdiodenchip gemäß dem unabhängigen Anspruch 1 gelöst. Vorteilhafte Ausgestaltungen und Weiterbildungen der Erfindung sind Gegenstand der abhängigen Ansprüche.

Der Leuchtdiodenchip enthält eine Halbleiterschichtenfolge, die eine zur Erzeugung von elektromagnetischer Strahlung geeignete aktive Schicht aufweist. Der Leuchtdiodenchip weist an der Vorderseite eine Strahlungsaustrittsfläche auf, durch die die von der aktiven Schicht emittierte elektromagnetische Strahlung aus der Halbleiterschichtenfolge austritt. Unter der Vorderseite des Leuchtdiodenchips wird hier und im Folgenden die Seite des Leuchtdiodenchips verstanden, an der die Strahlungsaustrittsfläche angeordnet ist.

An einer der Strahlungsaustrittsfläche gegenüberliegenden Rückseite weist der Leuchtdiodenchip zumindest bereichsweise eine Spiegelschicht auf, die Silber enthält. Auf der Spiegelschicht ist eine funktionelle Schicht zur Verminderung der Korrosion und/oder Verbesserung der Haftung der Spiegelschicht angeordnet, wobei ein Material, aus dem die funktionelle Schicht gebildet ist, auch in der Spiegelschicht enthalten ist.

Die Spiegelschicht grenzt unmittelbar an die Halbleiterschichtenfolge an. Zwischen der Halbleiterschichtenfolge und der Spiegelschicht ist also insbesondere keine Haftvermittlerschicht angeordnet, welche zu einer Verminderung der Reflexion an der Grenzfläche zwischen der Spiegelschicht und der Halbleiterschichtenfolge führen könnte. Es hat sich vielmehr herausgestellt, dass sich die für die Spiegelschicht gewünschten Eigenschaften einer guten Haftung auf dem Halbleitermaterial, eines guten elektrischen Anschlusses an das Halbleitermaterial und ein Schutz vor Korrosion und Silbermigration mit einer funktionellen Schicht erreichen lässt, die auf eine der Halbleiterschichtenfolge gegenüberliegenden Seite der Spiegelschicht aufgebracht ist, wobei das Material der funktionellen Schicht in der Spiegelschicht enthalten, insbesondere eindiffundiert, ist.

Insbesondere hat sich herausgestellt, dass ein Einbringen des Materials der funktionellen Schicht in die Spiegelschicht die Materialeigenschaften der Spiegelschicht in günstiger Weise beeinflussen kann. Das Einbringen des Materials der funktionellen Schicht in die Spiegelschicht erfolgt vorzugsweise durch Diffusion. Alternativ sind auch andere physikalische oder chemische Prozesse denkbar.

Eine Diffusion des Materials der funktionellen Schicht in die Spiegelschicht wird vorzugsweise durch einen Temperprozess nach dem Aufbringen der funktionellen Schicht auf die Spiegelschicht bewirkt. Durch die Wahl der Temperatur und der Zeit des Temperprozesses kann die Diffusion des Materials der funktionellen Schicht in die Spiegelschicht gezielt gesteuert werden.

Das Tempern erfolgt bevorzugt bei einer Temperatur zwischen 200 °C und 400 C°. Besonders bevorzugt werden Temperaturen zwischen 250 °C und 350 °C bei dem Temperprozess eingestellt. Die für das Tempern benötigte Zeit ist insbesondere von der verwendeten Temperatur abhängig und kann beispielsweise zwischen 1 Minute und 1 Stunde betragen.

Die funktionelle Schicht enthält bevorzugt Platin oder besteht daraus. Alternativ kann die funktionelle Schicht Nickel, Chrom, Palladium, Rhodium oder ein transparentes leitfähiges Oxid enthalten oder daraus bestehen. Bei dem transparenten leitfähigen Oxid kann es sich beispielsweise um ITO oder ZnO handeln.

Das Material der funktionellen Schicht ist in der gesamten Spiegelschicht verteilt. Beispielsweise kann das Material der funktionellen Schicht derart tief in die Spiegelschicht eindiffundiert sein, dass es auch an einer der funktionellen Schicht gegenüberliegenden Grenzfläche der Spiegelschicht nachweisbar ist. Es hat sich herausgestellt, dass auf diese Weise insbesondere die Haftung der Spiegelschicht auf der Halbleiterschichtenfolge verbessert werden kann. Dabei wird die Reflektivität der Spiegelschicht aber weniger beeinträchtigt, als wenn eine dünne Haftvermittlerschicht zwischen der Halbleiterschichtenfolge und der Spiegelschicht angeordnet würde.

Weiterhin hat sich herausgestellt, dass durch das Einbringen des Materials der funktionellen Schicht in die Silber enthaltende Spiegelschicht die Korrosion des Silbers vermindert werden kann. Die Ursache dieses Effekts ist theoretisch noch nicht vollständig verstanden. Es ist denkbar, dass das Material der funktionellen Schicht bevorzugt entlang der Silber-Korngrenzen diffundiert. Dies könnte zu einer Stabilisierung des Materials der Spiegelschicht beitragen, da Korrosionseffekte in der Regel an den metallischen Korngrenzen ansetzen. Weiterhin ist denkbar, dass das Material der funktionellen Schicht entsprechend seiner Stellung in der elektrochemischen Spannungsreihe die auftretenden elektrischen Potenziale derart modifiziert, dass Korrosionseffekte unterdrückt werden. Weiterhin ist es auch möglich, dass eine andere Eigenschaft des Materials der funktionellen Schicht, das in der Spiegelschicht verteilt ist, wie beispielsweise eine Wirkung als Katalysator oder die Speicherung von Wasserstoff, einen positiven Einfluss auf die Beständigkeit der Spiegelschicht hat.

Das Material der funktionellen Schicht ist in der Spiegelschicht nicht gleichmäßig verteilt, sondern weist einen Konzentrationsgradienten auf, wobei die Konzentration des Materials der funktionellen Schicht in der Spiegelschicht ausgehend von der von der funktionellen Schicht in Richtung zur Halbleiterschichtenfolge hin abnimmt. Insbesondere kann die Konzentration des Materials der funktionellen Schicht an der Grenzfläche der Spiegelschicht zur Halbleiterschichtenfolge geringer sein als an der Grenzfläche der Spiegelschicht zur funktionellen Schicht. Dies hat den Vorteil, dass die Reflektivität der Grenzfläche zwischen der Halbleiterschichtenfolge und der Spiegelschicht nur unwesentlich beeinträchtigt wird. Ein Konzentrationsgradient des Materials der funktionellen Schicht in der Spiegelschicht kann insbesondere dadurch erzielt werden, dass das Material der funktionellen Schicht in die Spiegelschicht eindiffundiert wird, beispielsweise durch einen Temperprozess.

Die funktionelle Schicht weist eine Dicke zwischen 10 nm und 100 nm auf. Es hat sich herausgestellt, dass besonders gute Ergebnisse bei einer Dicke der funktionellen Schicht zwischen einschließlich 10 nm und einschließlich 100 nm erzielt werden.

Bei einer bevorzugten Ausgestaltung ist die Spiegelschicht Bestandteil einer reflektierenden Kontaktschichtenfolge, die sowohl zur elektrischen Kontaktierung der Halbleiterschichtenfolge als auch zur Reflexion von Strahlung in Richtung zur Strahlungsaustrittsfläche des Leuchtdiodenchips dient. Die reflektierende Kontaktschichtenfolge weist vorzugsweise ausgehend von der Halbleiterschichtenfolge mindestens folgende Schichten in der genannten Reihenfolge auf: die Spiegelschicht, die Silber enthält, die funktionelle Schicht zur Verminderung der Korrosion und/oder Verbesserung der Haftung der Spiegelschicht, eine Diffusionsbarriereschicht und eine erste elektrische Anschlussschicht. Die Spiegelschicht grenzt dabei vorteilhaft unmittelbar an die Halbleiterschichtenfolge an.

Die erste elektrische Anschlussschicht ist vorzugsweise aus einem Material mit guter elektrischer Leitfähigkeit gebildet, um den Strom möglichst gleichmäßig in die Halbleiterschichtenfolge einzuprägen. Somit fungiert die erste elektrische Anschlussschicht auch als Stromaufweitungsschicht. Die erste elektrische Anschlussschicht ist mit einem der elektrischen Kontakte des Leuchtdiodenchips elektrisch leitend verbunden. Vorzugsweise ist die erste elektrische Anschlussschicht eine Goldschicht. Alternativ kann die erste elektrische Anschlussschicht beispielsweise auch Kupfer oder Nickel enthalten oder daraus bestehen.

Die zwischen der funktionellen Schicht und der ersten elektrische Anschlussschicht angeordnete Diffusionsbarriereschicht verhindert insbesondere eine Diffusion des Materials der ersten elektrischen Anschlussschicht, beispielsweise Gold, in die Silber enthaltende Spiegelschicht und umgekehrt.

Die Diffusionsbarriereschicht kann insbesondere eine Titanschicht sein. Alternativ kann die Diffusionsbarriereschicht beispielsweise Chrom, Nickel, Palladium, Titannitrid oder Titanwolframnitrid enthalten.

Zwischen der Diffusionsbarriereschicht und der ersten elektrischen Anschlussschicht ist vorzugsweise eine Haftschicht angeordnet. Bei der Haftschicht handelt es sich bevorzugt um eine Platinschicht. Alternativ kann die Haftschicht auch eine Chromschicht oder eine Titanschicht sein.

Als besonders vorteilhaft hat sich eine Schichtenfolge herausgestellt, bei der die funktionelle Schicht eine Platinschicht ist, die Diffusionsbarriereschicht eine Titanschicht ist, und die Haftschicht eine Platinschicht ist. Es hat sich herausgestellt, dass Titan eine sehr gute Diffusionsbarriere zwischen der Spiegelschicht, die Silber enthält, und der ersten elektrische Anschlussschicht, die vorzugsweise Gold enthält, darstellt. Andererseits ist Titan an sich aber anfällig gegen Korrosion oder Oxidation, was aber durch die Einbettung der Titanschicht zwischen zwei Platinschichten vorteilhaft vermieden werden kann.

Bei einer weiteren vorteilhaften Ausgestaltung ist der Leuchtdiodenchip an einer der Strahlungsaustrittsfläche gegenüberliegenden Seite mittels einer Lotschicht mit einem Träger verbunden. Bei dem Leuchtdiodenchip handelt es sich dabei vorzugsweise um einen so genannten Dünnfilm-Leuchtdiodenchip, bei dem ein zum epitaktischen Aufwachsen der Halbleiterschichtenfolge verwendetes Aufwachssubstrat von der Halbleiterschichtenfolge entfernt wurde und die Halbleiterschichtenfolge stattdessen an der dem ursprünglichen Aufwachssubstrat gegenüberliegenden Seite mittels einer Lotschicht mit einem Träger verbunden wurde.

Bei einer bevorzugten Ausgestaltung weist der Leuchtdiodenchip eine erste und eine zweite elektrische Anschlussschicht auf, wobei die erste und die zweite elektrische Anschlussschicht der Rückseite der Halbleiterschichtenfolge zugewandt und mittels einer Passivierungsschicht elektrisch voneinander isoliert sind, wobei sich ein Teilbereich der zweiten elektrischen Anschlussschicht von der Rückseite der Halbleiterschichtenfolge durch mindestens einen Durchbruch der aktiven Schicht hindurch in Richtung zu der Vorderseite hin erstreckt. Die zweite elektrische Anschlussschicht enthält Silber und fungiert bei dieser Ausgestaltung als zweite Spiegelschicht.

Vorteilhaft ist auf der zweiten elektrischen Anschlussschicht eine zweite funktionelle Schicht zur Verminderung der Korrosion und/oder Verbesserung der Haftung der zweiten elektrischen Anschlussschicht angeordnet, wobei ein Material, aus dem die zweite funktionelle Schicht gebildet ist, auch in der zweiten elektrischen Anschlussschicht enthalten ist. Die vorteilhaften Ausgestaltungen der zweiten elektrischen Anschlussschicht und der zweiten funktionellen Schicht entsprechen den zuvor beschriebenen vorteilhaften Ausgestaltungen der Spiegelschicht und der funktionellen Schicht. Insbesondere kann die zweite funktionelle Schicht eine Platinschicht sein.

Bei einer bevorzugten Ausgestaltung ist die zweite elektrische Anschlussschicht zumindest bereichsweise Bestandteil einer Schichtenfolge, die mindestens die folgenden Schichten in der genannten Reihenfolge enthält: die Passivierungsschicht, die zweite elektrische Anschlussschicht, die zweite funktionelle Schicht, eine Diffusionsbarriereschicht und eine Lotschicht. Mittels der Lotschicht ist der Leuchtdiodenchip vorzugsweise an einer der Strahlungsaustrittsfläche gegenüberliegenden Seite mit einem Träger verbunden. Bei der Lotschicht kann es sich beispielsweise um eine AuSn-Schicht handeln.

Die Diffusionsbarriereschicht zwischen der zweiten elektrischen Anschlussschicht und der Lotschicht verhindert eine Interdiffusion der Materialien der Lotschicht und der zweiten elektrischen Anschlussschicht. Bevorzugt ist die Diffusionsbarriereschicht eine Titanwolframnitrid-Schicht.

Zwischen der Passivierungsschicht und der zweiten elektrischen Anschlussschicht kann eine Haftschicht enthalten sein, durch die die Haftung der zweiten elektrischen Anschlussschicht auf der Passivierungsschicht verbessert wird. Vorzugsweise ist die Haftschicht eine Titanschicht.

Die Erfindung wird im Folgenden anhand eines Ausführungsbeispiels im Zusammenhang mit den Figuren 1 bis 3 näher erläutert.

Es zeigen:
- Figur 1: eine schematische Darstellung eines Querschnitts durch einen Leuchtdiodenchip gemäß einem Ausführungsbeispiel der Erfindung,
- Figur 2: eine Detailansicht des Bereichs A des in Figur 1 dargestellten Leuchtdiodenchips, und
- Figur 3: eine Detailansicht des Bereichs B des in Figur 1 dargestellten Leuchtdiodenchips.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

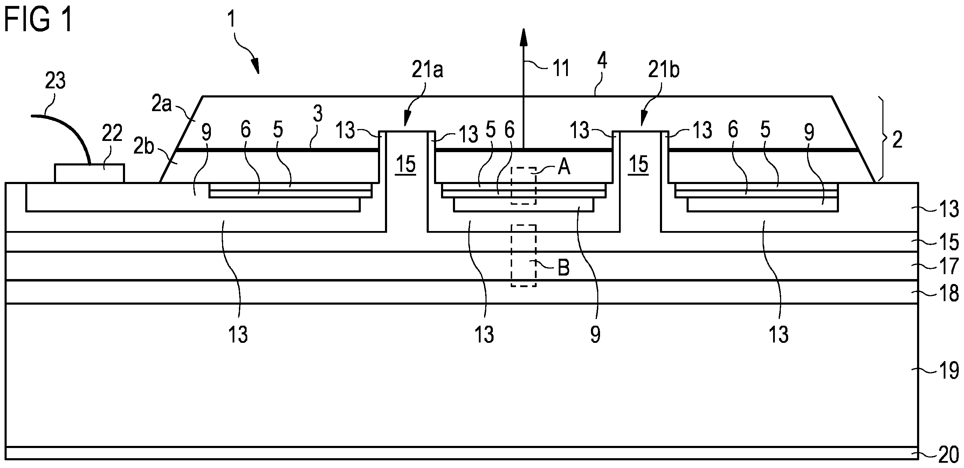

Der in Figur 1 dargestellte Leuchtdiodenchip 1 weist eine Halbleiterschichtenfolge 2 auf, die eine zur Emission von elektromagnetischer Strahlung 11 vorgesehene aktive Schicht 3 aufweist.

Die aktive Schicht 3 des Leuchtdiodenchips 1 kann zum Beispiel als pn-Übergang, als Doppelheterostruktur, als Einfach-Quantentopfstruktur oder Mehrfach-Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Die Halbleiterschichtenfolge 2 kann insbesondere auf einem Nitridverbindungshalbleiter basieren. "Auf einem Nitridverbindungshalbleiter basierend" bedeutet im vorliegenden Zusammenhang, dass die Halbleiterschichtenfolge 2 oder zumindest eine Schicht davon ein III-Nitrid-Verbindungshalbleitermaterial, vorzugsweise InₓAl_{y}Ga_{1-x-y}N umfasst, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des InₓAl_{y}Ga_{1-x-y}N-Materials im Wesentlichen nicht ändern. Der Einfachheit halber beinhaltet obige Formel jedoch nur die wesentlichen Bestandteile des Kristallgitters (In, Al, Ga, N), auch wenn diese teilweise durch geringe Mengen weiterer Stoffe ersetzt sein können.

Der Leuchtdiodenchip 1 emittiert elektromagnetische Strahlung 11 durch eine Strahlungsaustrittsfläche 4, die an der Vorderseite des Leuchtdiodenchips 1 angeordnet ist. Zur Verbesserung der Strahlungsauskopplung kann die Strahlungsaustrittsfläche 4 mit einer Aufrauung oder einer Auskoppelstruktur versehen sein (nicht dargestellt).

Bei dem Leuchtdiodenchip 1 handelt es sich um einen so genannten Dünnfilm-Leuchtdiodenchip. Bei dem Dünnfilm-Leuchtdiodenchip ist das ursprüngliche Aufwachssubstrat der Halbleiterschichtenfolge 2 von dem Leuchtdiodenchip 1 abgelöst worden und stattdessen der Leuchtdiodenchip 1 an einer dem ursprünglichen Aufwachssubstrat gegenüberliegenden Seite mittels einer Lotschicht 18 mit einem Träger 19 verbunden worden. Das ursprüngliche Aufwachssubstrat kann insbesondere von der nun als Strahlungsaustrittsfläche 4 fungierenden Oberfläche der Halbleiterschichtenfolge 2 abgelöst sein. Bei dem Leuchtdiodenchip 1 ist daher ein n-dotierter Halbleiterbereich 2a, der üblicherweise zuerst auf das Aufwachssubstrat aufgewachsen wird, der Strahlungsaustrittsfläche 4 zugewandt. Ein p-dotierter Halbleiterbereich 2b der Halbleiterschichtenfolge 2 ist dem Träger 19 zugewandt. Der Träger 19 kann beispielsweise Germanium oder Silizium aufweisen.

Um die Effizienz des Leuchtdiodenchips 1 zu verbessern, weist der Leuchtdiodenchip 1 an einer der Strahlungsaustrittsfläche 4 gegenüberliegenden Rückseite bereichsweise eine Spiegelschicht 5 auf. Die Spiegelschicht 5 ist zwischen dem p-dotierten Halbleiterbereich 2b und einer ersten elektrischen Anschlussschicht 9 des Leuchtdiodenchips angeordnet. Durch die Spiegelschicht 5 wird vorteilhaft Strahlung, die von der aktiven Schicht 3 in Richtung des Trägers 19 emittiert wird, zu der Strahlungsaustrittsfläche 4 hin reflektiert.

Die Spiegelschicht 5 ist Bestandteil einer reflektierenden Kontaktschichtenfolge, die zwischen der Spiegelschicht 5 und der ersten elektrischen Anschlussschicht 9 weitere Schichten umfasst, von denen in Figur 1 zur Vereinfachung der Darstellung nicht alle Schichten gezeigt sind.

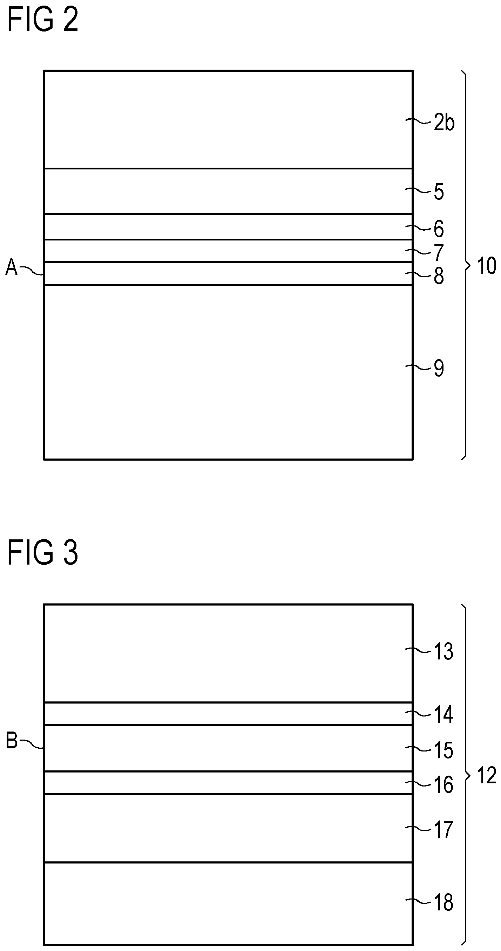

Der Aufbau der reflektierenden Kontaktschichtenfolge 10 ist in Figur 2 dargestellt, in der eine Detailansicht des Ausschnitts A der Figur 1 gezeigt ist. Die Spiegelschicht 5, die Silber enthält, grenzt unmittelbar an den p-dotierten Bereich 2b der Halbleiterschichtenfolge 2 an. An der von der Halbleiterschichtenfolge 2 abgewandten Seite ist eine funktionelle Schicht 6 auf der Spiegelschicht 5 angeordnet. Die funktionelle Schicht 6 dient zur Verminderung der Korrosion und/oder Verbesserung der Haftung und/oder Verbesserung des elektrischen Anschlusses der Spiegelschicht an die Halbleiterschichtenfolge 2. Dies wird insbesondere dadurch erreicht, dass das Material, aus dem die funktionelle Schicht 6 gebildet ist, zumindest teilweise auch in der Spiegelschicht 5 enthalten ist. Insbesondere kann das Material der funktionellen Schicht 6 in die Spiegelschicht 5 eindiffundiert sein.

Um das Material der funktionellen Schicht 6 in die Spiegelschicht 5 einzudiffundieren, wird die funktionelle Schicht 6 bei einem Verfahren zur Herstellung des Leuchtdiodenchips 1 nach dem Aufbringen auf die Spiegelschicht 5 vorzugsweise getempert. Das Tempern erfolgt vorzugsweise bei einer Temperatur zwischen einschließlich 200 °C und einschließlich 400 °C, insbesondere bei Temperaturen zwischen 250 °C und 350 °C. Die Zeit für den Temperprozess kann beispielsweise zwischen einer Minute und einer Stunde betragen.

Das Material der funktionellen Schicht 6 ist in der gesamten Spiegelschicht 5 enthalten,insbesondere auch in dem an die Halbleiterschichtenfolge 2 angrenzenden Bereich der Spiegelschicht 5.

Es hat sich herausgestellt, dass dadurch, dass das Material der funktionellen Schicht 6 auch in der Spiegelschicht 5 enthalten ist, die Langzeitstabilität der Spiegelschicht 5 verbessert werden kann. Insbesondere wird auf diese Weise eine Korrosion der Spiegelschicht 5 vermindert und die Haftung auf der Halbleiterschichtenfolge 2 verbessert. Weiterhin stellt eine solche Spiegelschicht 5 einen guten elektrischen Anschluss an das Halbleitermaterial der Halbleiterschichtenfolge 2 her.

Das in der Spiegelschicht 5 enthaltene Material der funktionellen Schicht 6 weist innerhalb der Spiegelschicht 5 einen Konzentrationsgradienten auf. Insbesondere kann durch den Prozess des Eindiffundierens die Konzentration des Materials der funktionellen Schicht 6 an einer der Halbleiterschichtenfolge 2 zugewandten Seite der Spiegelschicht 5 geringer sein als an der der funktionellen Schicht 6 zugewandten Seite. Die Reflektivität der Silber enthaltenden Spiegelschicht 5 an der Grenzfläche zur Halbleiterschichtenfolge 2 wird daher nur geringfügig beeinträchtigt. Insbesondere wird die Reflektivität der Spiegelschicht 5 durch das darin enthaltene zusätzliche Material der funktionellen Schicht 6 weniger beeinträchtigt, als wenn man eine Haftschicht zwischen der Halbleiterschichtenfolge 2 und der Spiegelschicht 5 einfügen würde.

Als besonders vorteilhaft hat sich eine funktionelle Schicht 6 aus Platin herausgestellt. Alternativ ist es aber auch denkbar, dass die funktionelle Schicht 6 Nickel, Chrom, Palladium, Rhodium oder ein transparentes leitfähiges Oxid, wie beispielsweise ITO oder ZnO, enthält. Eine besonders gute Verbesserung der Stabilität der Spiegelschicht 5 wird mit einer funktionellen Schicht 6 erreicht, die eine Dicke zwischen einschließlich 10 nm und einschließlich 100 nm aufweist.

Auf die funktionelle Schicht 6 folgt in der reflektierenden Kontaktschichtenfolge 10 eine Diffusionsbarriereschicht 7, bei der es sich vorzugsweise um eine Titanschicht handelt. Alternative Materialien für die Diffusionsbarriereschicht sind Chrom, Nickel, Palladium, Titannitrid oder Titanwolframnitrid. Die Diffusionsbarriereschicht 7 verhindert eine Interdiffusion der Materialien der Spiegelschicht 5, insbesondere Silber, und der ersten elektrischen Anschlussschicht 9, beispielsweise Gold.

Auf die Diffusionsbarriereschicht 7 folgt eine Haftschicht 8, durch die die Haftung der nachfolgenden ersten elektrischen Anschlussschicht 9 verbessert wird. Die Haftschicht 8 ist vorzugsweise eine Platinschicht, wobei aber alternativ auch Titan oder Chrom als Materialien für die Haftschicht geeignet sind.

Die erste elektrische Anschlussschicht 9 ist bevorzugt eine Goldschicht. Alternativ kann die erste elektrische Anschlussschicht auch aus einem anderen Material mit einer guten elektrischen Leitfähigkeit, beispielsweise Kupfer oder Nickel, gebildet sein.

Bei einer besonders vorteilhaften Ausführung der reflektierenden Kontaktschichtenfolge 10 ist die funktionelle Schicht 6 eine Platinschicht, die Diffusionsbarriereschicht 7 eine Titanschicht und die Haftschicht 8 eine Platinschicht. Es hat sich herausgestellt, dass Titan eine sehr gute Diffusionsbarriere zwischen der Spiegelschicht 5 und der ersten elektrischen Anschlussschicht 9 darstellt, wobei die zwei umgebenden Platinschichten die Titanschicht besonders gut gegen Korrosion und/oder Oxidation schützen.

Wie in Figur 1 dargestellt, weist der Leuchtdiodenchip 1 eine zweite elektrische Anschlussschicht 15 auf, durch die der Leuchtdiodenchip 1 von einer der Strahlungsaustrittsfläche 4 gegenüberliegenden Rückseite kontaktiert wird. Es sind also sowohl die erste elektrische Anschlussschicht 9 als auch die zweite elektrische Anschlussschicht 15 an einer dem Träger 19 zugewandten Rückseite des Leuchtdiodenchips 1 angeordnet. Dies hat den Vorteil, dass die Strahlungsaustrittsfläche 4 frei von elektrischen Anschlussschichten ist, sodass die von dem Leuchtdiodenchip 1 emittierte elektromagnetische Strahlung 11 nicht von einer der elektrischen Anschlussschichten 9, 15 abgeschattet wird.

Die erste elektrische Anschlussschicht 9 kontaktiert vorzugsweise den p-dotierten Bereich 2b der Halbleiterschichtenfolge 2. Die zweite elektrische Anschlussschicht 15 kontaktiert vorzugsweise den n-dotierten Bereich 2a der Halbleiterschichtenfolge 2. Die zweite elektrische Anschlussschicht 15 ist dazu von der Rückseite des Leuchtdiodenchips 1 her durch einen oder mehrere Durchbrüche 21a, 21b, die durch den p-dotierten Bereich 2b der Halbleiterschichtenfolge und die aktive Schicht 3 hindurch verlaufen, bis in den n-dotierten Bereich 2a der Halbleiterschichtenfolge 2 geführt. Zur Verhinderung eines Kurzschlusses ist die zweite elektrische Anschlussschicht 15 im Bereich der Durchbrüche 21a, 21b mittels einer Passivierungsschicht 13 von der aktiven Schicht 3 und dem p-dotierten Bereich 2b der Halbleiterschichtenfolge 2 elektrisch isoliert.

Weiterhin isoliert die Passivierungsschicht 13 die zweite elektrische Anschlussschicht 15 auch von der ersten elektrischen Anschlussschicht 9. Die Passivierungsschicht 13 ist aus einem elektrisch isolierenden Material wie beispielsweise SiO₂ oder SiN gebildet.

Die zweite elektrische Anschlussschicht 15 enthält Silber und fungiert insbesondere im Bereich der Durchbrüche 21a, 21b als zweite Spiegelschicht für die von dem Leuchtdiodenchip 1 emittierte elektromagnetische Strahlung 11.

Zwischen der Lotschicht 18 und der zweiten elektrischen Anschlussschicht 15 ist eine Diffusionsbarriereschicht 17 angeordnet. Zwischen der Passivierungsschicht 13, der zweiten elektrischen Anschlussschicht 15 und der Diffusionsbarriereschicht 17 sind weitere Schichten angeordnet, die in Figur 1 zur Vereinfachung der Darstellung nicht dargestellt sind. Diese Schichten sind in Figur 3, die eine Detailansicht des Ausschnitts B in Figur 1 darstellt, gezeigt.

Zwischen der Passivierungsschicht 13 und der zweiten elektrischen Anschlussschicht 15, die Silber enthält und als zweite Spiegelschicht wirkt, kann eine Haftschicht 14 angeordnet sein. Bei der Haftschicht 14 handelt es sich vorzugsweise um eine Titanschicht. Die Haftschicht 14 kann optional auch weggelassen werden.

Auf einer der Passivierungsschicht 13 gegenüberliegenden Seite ist auf die zweite elektrische Anschlussschicht 15 eine zweite funktionelle Schicht 16 aufgebracht, die vorzugsweise eine Platinschicht ist. Die zweite funktionelle Schicht 16 entspricht in ihrer Wirkungsweise und vorteilhaften Ausgestaltungen der zuvor im Zusammenhang mit der Spiegelschicht 5 beschriebenen funktionellen Schicht 6. Insbesondere ist das Material der funktionellen Schicht 16 auch in der zweiten elektrischen Anschlussschicht 15 enthalten.

In der Schichtenfolge 12 folgt auf die funktionelle Schicht 16 eine Diffusionsbarriereschicht 17, die vorzugsweise Titanwolframnitrid enthält. Auf die Diffusionsbarriereschicht 17 folgt die Lotschicht 18, mit der der Leuchtdiodenchip 1 auf den Träger 19 gelötet ist. Die Lotschicht 18 kann insbesondere AuSn enthalten. Die Diffusionsbarriereschicht 17 verhindert, dass ein Bestandteil der Lotschicht 18 in die zweite elektrische Anschlussschicht 15 diffundiert und umgekehrt.

Bei dem in Figur 1 dargestellten Träger 19 des Leuchtdiodenchips kann es sich beispielsweise um einen Germanium-Träger handeln. An der vom Leuchtdiodenchip 1 abgewandten Rückseite des Trägers kann eine Kontaktmetallisierung 20 aufgebracht sein, über die die zweite elektrische Anschlussschicht 15 nach außen elektrisch angeschlossen wird. Die erste elektrische Anschlussschicht 9 kann beispielsweise über ein Bondpad 22 und einen Bonddraht 23 elektrisch nach außen angeschlossen werden.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Leuchtdiodenchip (1) mit einer Halbleiterschichtenfolge (2), die eine zur Erzeugung von elektromagnetischer Strahlung (11) geeignete aktive Schicht (3) aufweist, wobei
- der Leuchtdiodenchip (1) an einer Vorderseite eine Strahlungsaustrittsfläche (4) aufweist,
- der Leuchtdiodenchip (1) an einer der Strahlungsaustrittsfläche (4) gegenüberliegenden Rückseite zumindest bereichsweise eine Spiegelschicht (5) aufweist, die Silber enthält,
- auf der Spiegelschicht (5) eine funktionelle Schicht (6) angeordnet ist,
- ein Material, aus dem die funktionelle Schicht (6) gebildet ist, auch in der gesamten Spiegelschicht (5) verteilt ist, wobei das Material der funktionellen Schicht (6) in der Spiegelschicht (5) einen Konzentrationsgradienten aufweist,
- die Konzentration des Materials der funktionellen Schicht (6) in der Spiegelschicht (5) ausgehend von der funktionellen Schicht (6) in Richtung zur Halbleiterschichtenfolge (2) hin abnimmt, und
- die Spiegelschicht (5) unmittelbar an die Halbleiterschichtenfolge (2) angrenzt,
**dadurch gekennzeichnet, dass**
- die funktionelle Schicht (6) zur Verminderung der Korrosion und/oder Verbesserung der Haftung der Spiegelschicht (5) eine Dicke zwischen 10 nm und 100 nm aufweist.

2. Leuchtdiodenchip nach Anspruch 1,
wobei die funktionelle Schicht (6) Platin enthält.

3. Leuchtdiodenchip nach Anspruch 1,
wobei die funktionelle Schicht (6) Nickel, Chrom, Palladium, Rhodium oder ein transparentes leitfähiges Oxid enthält.

4. Leuchtdiodenchip nach einem der vorhergehenden Ansprüche,
wobei die Spiegelschicht (5) Bestandteil einer reflektierenden Kontaktschichtenfolge (10) ist, die ausgehend von der Halbleiterschichtenfolge (2) mindestens folgende Schichten in der genannten Reihenfolge aufweist:
- die Spiegelschicht (5), die Silber enthält,
- die funktionelle Schicht (6) zur Verminderung der Korrosion und/oder Verbesserung der Haftung der Spiegelschicht (5),
- eine Diffusionsbarriereschicht (7), und
- eine erste elektrische Anschlussschicht (9).

5. Leuchtdiodenchip nach Anspruch 4,
wobei die erste elektrische Anschlussschicht (9) Gold enthält.

6. Leuchtdiodenchip nach einem der Ansprüche 4 oder 5, wobei die Diffusionsbarriereschicht (7) Titan, Chrom, Nickel, Palladium, Titannitrid oder Titanwolframnitrid enthält.

7. Leuchtdiodenchip nach einem der Ansprüche 4 bis 6, wobei zwischen der Diffusionsbarriereschicht (7) und der ersten elektrischen Anschlussschicht (9) eine Haftschicht (8) angeordnet ist.

8. Leuchtdiodenchip nach Anspruch 7,
wobei die Haftschicht (8) Platin, Titan oder Chrom enthält.

9. Leuchtdiodenchip nach einem der vorhergehenden Ansprüche,
wobei
- der Leuchtdiodenchip (1) eine erste elektrische Anschlussschicht (9) und eine zweite elektrische Anschlussschicht (15) aufweist,
- die erste elektrische Anschlussschicht (9) und die zweite elektrische Anschlussschicht (15) der Rückseite der Halbleiterschichtenfolge (2) zugewandt und mittels einer Passivierungsschicht (13) elektrisch voneinander isoliert sind,
- sich ein Teilbereich der zweiten elektrischen Anschlussschicht (15) von der Rückseite der Halbleiterschichtenfolge (2) durch mindestens einen Durchbruch (21a, 21b) der aktiven Schicht (3) hindurch in Richtung zu der Vorderseite hin erstreckt,
- die zweite elektrische Anschlussschicht (15) Silber enthält und als zweite Spiegelschicht fungiert,
- auf der zweiten elektrischen Anschlussschicht (15) eine zweite funktionelle Schicht (16) zur Verminderung der Korrosion und/oder Verbesserung der Haftung der zweiten elektrischen Anschlussschicht (15) angeordnet ist, wobei ein Material, aus dem die zweite funktionelle Schicht (16) gebildet ist, auch in der zweiten elektrischen Anschlussschicht (15) enthalten ist.

10. Leuchtdiodenchip nach Anspruch 9,
wobei die zweiten elektrische Anschlussschicht (15) zumindest bereichsweise Bestandteil einer Schichtenfolge (12) ist, die mindestens die folgenden Schichten in der genannten Reihenfolge enthält:
die Passivierungsschicht (13),
die zweite elektrische Anschlussschicht (15),
die zweite funktionelle Schicht (16),
eine Diffusionsbarriereschicht (17), und
eine Lotschicht (18).

11. Leuchtdiodenchip nach Anspruch 10,
wobei der Leuchtdiodenchip (1) an einer der Strahlungsaustrittsfläche (4) gegenüber liegenden Seite mittels der Lotschicht (18) mit einem Träger (19) verbunden ist.

## Claims

1. Light emitting diode chip (1) comprising a semiconductor layer sequence (2), which has an active layer (3) suitable for generating electromagnetic radiation (11), wherein
- the light emitting diode chip (1) has a radiation exit area (4) at a front side,
- the light emitting diode chip (1) has, at a rear side lying opposite the radiation exit area (4), at least in regions, a mirror layer (5) containing silver,
- a functional layer (6) is arranged on the mirror layer (5),
- a material from which the functional layer (6) is formed is also distributed in the entire mirror layer (5), wherein the material of the functional layer (6) has a concentration gradient in the mirror layer (5),
- the concentration of the material of the functional layer (6) in the mirror layer (5), decreases proceeding from the functional layer (6) in the direction toward the semiconductor layer sequence (2), and
- the mirror layer (5) directly adjoins the semiconductor layer sequence (2),
**characterized in that**
- the functional layer (6), for reducing corrosion and/or improving adhesion of the mirror layer (5), has a thickness of between 10 nm and 100 nm.

2. Light emitting diode chip according to Claim 1, wherein the functional layer (6) contains platinum.

3. Light emitting diode chip according to Claim 1, wherein the functional layer (6) contains nickel, chromium, palladium, rhodium or a transparent conductive oxide.

4. Light emitting diode chip according to any of the preceding claims,
wherein the mirror layer (5) is part of a reflective contact layer sequence (10), which has, preceding from the semiconductor layer sequence (2), at least the following layers in the stated order:
- the mirror layer (5) containing silver,
- the functional layer (6) for reducing corrosion and/or improving adhesion of the mirror layer (5),
- a diffusion barrier layer (7), and
- a first electrical connection layer (9).

5. Light emitting diode chip according to Claim 4,
wherein the first electrical connection layer (9) contains gold.

6. Light emitting diode chip according to either of Claims 4 and 5,
wherein the diffusion barrier layer (7) contains titanium, chromium, nickel, palladium, titanium nitride or titanium tungsten nitride.

7. The light emitting diode chip according to any of Claims 4 to 6,
wherein an adhesion layer (8) is arranged between the diffusion barrier layer (7) and the first electrical connection layer (9).

8. Light emitting diode chip according to Claim 7,
wherein the adhesion layer (8) contains platinum, titanium or chromium.

9. Light emitting diode chip according to any of the preceding claims,
wherein
- the light emitting diode chip (1) has a first electrical connection layer (9) and a second electrical connection layer (15),
- the first electrical connection layer (9) and the second electrical connection layer (15) face the rear side of the semiconductor layer sequence (2) and are electrically insulated from one another by means of a passivation layer (13),
- a partial region of the second electrical connection layer (15) extends from the rear side of the semiconductor layer sequence (2) through at least one perforation (21a, 21b) of the active layer (3) in the direction toward the front side,
- the second electrical connection layer (15) contains silver and functions as a second mirror layer,
- a second functional layer (16) for reducing corrosion and/or improving adhesion of the second electrical connection layer (15) is arranged on the second electrical connection layer (15), wherein a material from which the second functional layer (16) is formed is also contained in the second electrical connection layer (15).

10. Light emitting diode chip according to Claim 9,
wherein the second electrical connection layer (15) is, at least in regions, part of a layer sequence (12) containing at least the following layers in the stated order:
the passivation layer (13),
the second electrical connection layer (15),
the second functional layer (16),
a diffusion barrier layer (17), and
a solder layer (18).

11. Light emitting diode chip according to Claim 10,
wherein the light emitting diode chip (1) is connected, at a side lying opposite the radiation exit area (4), to a carrier (19) by means of the solder layer (18).

## Revendications

1. Puce de diode électroluminescente (1) comprenant une séquence de couches en semiconducteur (2) qui possède une couche active (3) adaptée pour générer un rayonnement électromagnétique (11),
- la puce de diode électroluminescente (1) possédant une surface de sortie de rayonnement (4) sur un côté avant,
- la puce de diode électroluminescente (1) possédant, au moins dans certaines zones sur un côté arrière opposé à la surface de sortie de rayonnement (4), une couche réfléchissante (5) qui contient de l'argent,
- une couche fonctionnelle (6) étant disposée sur la couche réfléchissante (5),
- un matériau duquel est constituée la couche fonctionnelle (6) étant réparti également dans la totalité de la couche réfléchissante (5), le matériau de la couche fonctionnelle (6) présentant un gradient de concentration dans la couche réfléchissante (5),
- la concentration du matériau de la couche fonctionnelle (6) dans la couche réfléchissante (5) diminuant à partir de la couche fonctionnelle (6) dans la direction de la séquence de couches en semiconducteur (2), et
- la couche réfléchissante (5) étant directement adjacente de la séquence de couches en semiconducteur (2),
**caractérisée en ce que**
- la couche fonctionnelle (6) destinée à réduire la corrosion et/ou améliorer l'adhérence de la couche réfléchissante (5) présente une épaisseur comprise entre 10 nm et 100 nm.

2. Puce de diode électroluminescente selon la revendication 1, la couche fonctionnelle (6) contenant du platine.

3. Puce de diode électroluminescente selon la revendication 1, la couche fonctionnelle (6) contenant du nickel, du chrome, du palladium, du rhodium ou un oxyde conducteur transparent.

4. Puce de diode électroluminescente selon l'une des revendications précédentes,
la couche réfléchissante (5) étant un élément constitutif d'une séquence de couches de contact (10) réfléchissantes qui, en partant de la séquence de couches en semiconducteur (2), possède les couches suivantes dans l'ordre indiqué :
- la couche réfléchissante (5) qui contient de l'argent,
- la couche fonctionnelle (6) destinée à réduire la corrosion et/ou à améliorer l'adhérence de la couche réfléchissante (5),
- une couche barrière de diffusion (7) et
- une première couche de raccordement électrique (9).

5. Puce de diode électroluminescente selon la revendication 4, la première couche de raccordement électrique (9) contenant de l'or.

6. Puce de diode électroluminescente selon l'une des revendications 4 ou 5, la couche barrière de diffusion (7) contenant du titane, du chrome, du nickel, du palladium, du nitrure de titane ou du nitrure de titane-tungstène.

7. Puce de diode électroluminescente selon l'une des revendications 4 à 6, une couche d'adhérence (8) étant disposée entre la couche barrière de diffusion (7) et la première couche de raccordement électrique (9).

8. Puce de diode électroluminescente selon la revendication 7, la couche d'adhérence (8) contenant du platine, du titane ou du chrome.

9. Puce de diode électroluminescente selon l'une des revendications précédentes,
- la puce de diode électroluminescente (1) possédant une première couche de raccordement électrique (9) et une deuxième couche de raccordement électrique (15),
- la première couche de raccordement électrique (9) et la deuxième couche de raccordement électrique (15) faisant face au côté arrière de la séquence de couches en semiconducteur (2) et étant isolées électriquement l'une de l'autre au moyen d'une couche de passivation (13),
- une zone partielle de la deuxième couche de raccordement électrique (15) s'étendant depuis le côté arrière de la séquence de couches en semiconducteur (2) à travers au moins une percée (21a, 21b) de la couche active (3) en direction du côté avant,
- la deuxième couche de raccordement électrique (15) contenant de l'argent et faisant office de deuxième couche réfléchissante,
- une deuxième couche fonctionnelle (16) destinée à réduire la corrosion et/ou améliorer l'adhérence de la deuxième couche de raccordement électrique (15) étant disposée sur la deuxième couche de raccordement électrique (15), un matériau duquel est constituée la deuxième couche fonctionnelle (16) étant également contenu dans la deuxième couche de raccordement électrique (15).

10. Puce de diode électroluminescente selon la revendication 9,
la deuxième couche de raccordement électrique (15) étant au moins dans certaines zones un élément constitutif d'une séquence de couches (12) qui contient au moins les couches suivantes, dans l'ordre indiqué :
la couche de passivation (13),
la deuxième couche de raccordement électrique (15),
la deuxième couche fonctionnelle (16),
une couche barrière de diffusion (17), et
une couche de brasure (18).

11. Puce de diode électroluminescente selon la revendication 10, la puce de diode électroluminescente (1) étant reliée à un support (19) au moyen de la couche de brasure (18) par un côté qui se trouve à l'opposé de la une surface de sortie de rayonnement (4).
